# EUROPÄISCHE PATENTSCHRIFT

(11) **EP 2 758 789 B1**
(45) Veröffentlichungstag und Bekanntmachung des Hinweises auf die Patenterteilung: **15.05.2019**
(21) Anmeldenummer: 12769351.3
(22) Anmeldetag: 20.09.2012
(51) Int. Cl.: G01R 1/20, G01R 19/32, H02J 7/14, G01R 31/36

(54) **VORRICHTUNG ZUR MESSUNG EINES BATTERIESTROMS**
DEVICE FOR MEASURING A BATTERY CURRENT
DISPOSITIF DE MESURE DE COURANT DE BATTERIE

(30) Priorität: 23.09.2011 DE 102011083307
(43) Veröffentlichungstag der Anmeldung: 30.07.2014
(73) Patentinhaber: Continental Automotive GmbH, 30165 Hannover (DE)
(72) Erfinder: SCHRAMME, Martin, 86343 Königsbrunn (DE); GRAF, Hans-Michael, 93049 Regensburg (DE)
(74) Vertreter: Gerschütz, Florian Matthias
(86) Internationale Anmeldenummer: PCT/EP2012/068502
(87) Internationale Veröffentlichungsnummer: WO 2013/041603

(56) Entgegenhaltungen:
- WO-A1-01/27641
- WO-A1-98/09176
- WO-A1-2011/060820
- DE-A1-102004 007 851
- JP-A- 2005 188 972
- US-A1- 2004 212 342
- US-A1- 2009 087 725
- US-A1- 2009 184 683
- DATABASE WPI Week 200554 Thomson Scientific, London, GB; AN 2005-525079 XP002689201, -& JP 2005 188945 A (AUTO NETWORK GIJUTSU KENKYUSHO; SUMITOMO WIRING SYSTEMS; SUMITOMO ELEC) 14. Juli 2005 (2005-07-14)
- ZIEGLER S ET AL: "Investigation Into Static and Dynamic Performance of the Copper Trace Current Sense Method", IEEE SENSORS JOURNAL, Bd. 9, Nr. 7, 1. Juli 2009 (2009-07-01), Seiten 782-792, XP011261486, IEEE SERVICE CENTER, NEW YORK, NY, US ISSN: 1530-437X
- Anonymous: "PS3180 SmartShunt TM Battery Monitor", INTERNET CITATION, 2000, XP002960182, Gefunden im Internet: URL:http://web.archive.org/web/20010425114 544/http://www.powersmart.com/products/dat asheets.cfm?Datasheetid=26&sidenav=3 [gefunden am 2002-06-24]

## Beschreibung

Die vorliegende Erfindung betrifft eine Vorrichtung zur Messung eines Batteriestroms einer Batterie eines Fahrzeuges.

Eine solche Vorrichtung ist beispielsweise aus der DE 10 2007 045 512 A1 bekannt. Dort ist ein Pol einer Autobatterie durch ein Kabel mit der Karosserie verbunden. Zwischen dem Kabel und dem Pol der Autobatterie befindet sich ein Shunt. Wie beispielsweise die DE 10 2004 033 836 B3 beschreibt, wird die über diesen Shunt abfallende Spannung einer Messeinrichtung zugeführt, um auf diese Weise den Strom zu ermitteln, der durch den Shunt fließt. Der Vorteil des Shunts liegt darin, dass sein Widerstand weitgehend temperaturunabhängig ist. Er verursacht jedoch nicht unerhebliche Kosten.

In der US 2009/184683 A1 und der US 2009/087725 A1 ist jeweils zusätzlich ein Temperatursensor vorgesehen, der die Temperatur des Shunts erfasst, um temperaturbedingte Änderungen des elektrischen Widerstandes des Shunts ausgleichen zu können.

In der WO 01 27641 wird ein Referenzstrom mit bekannter Größe an den Shunt angelegt und der Spannungsabfall durch den Referenzstrom am Shunt ermittelt, um aus dem Spannungsabfall und dem bekannten Referenzstrom den elektrischen Widerstand des Shunts zu ermittelt.

In der JP 2005-188945 A ist eine weitere Messvorrichtung gezeigt.

Es ist eine Aufgabe der vorliegenden Erfindung, eine kostengünstige Vorrichtung zur Messung eines Batteriestroms bereit zu stellen.

Erfindungsgemäß wird diese Aufgabe durch eine Vorrichtung mit den Merkmalen des Patentanspruches 1 gelöst. Ausführungsformen der erfindungsgemäßen Vorrichtung sind in den abhängigen Ansprüchen angegeben.

Die Erfindung umfasst eine Vorrichtung zur Messung eines Batteriestromes einer Batterie eines Fahrzeugs. Die Vorrichtung weist eine Messstrecke auf, über die der gesamte zu messende Batteriestrom während der Messung fließt. Unter einem Batteriestrom im Sinne der vorliegenden Patentanmeldung soll dabei jeglicher Strom verstanden werden, der die in der Batterie gespeicherte Ladung erhöht oder erniedrigt. Zum Messen eines Spannungsabfalls über die Messstrecke weist die erfindungsgemäße Vorrichtung eine Messeinrichtung auf. Darüber hinaus besitzt die erfindungsgemäße Vorrichtung eine Stromermittlungseinrichtung zum Ermitteln des Batteriestromes basierend auf dem gemessenen Spannungsabfall und einem Widerstand der Messstrecke. Die Messstrecke wird durch zumindest einen Teil eines Kabels mit einem temperaturabhängigen Widerstand gebildet. Die Vorrichtung ist dazu eingerichtet, einen vorherbestimmten Messstrom entlang der Messstrecke zu multiplexen. Des Weiteren umfasst die Vorrichtung eine Widerstandskompensationseinrichtung, die dazu eingerichtet ist, einen Kompensationsspannungsabfall zu ermitteln, der aufgrund des vorherbestimmten Messstroms entlang der Messstrecke abfällt, und den Widerstand der Messstrecke mit Hilfe des Kompensationsspannungsabfalls und des vorherbestimmten Messstroms zu kompensieren. Darüber hinaus umfasst die erfindungsgemäße Vorrichtung ein parallel zum Kabel verlaufendes, mit dem Kabel thermisch gekoppeltes Kompensationskabel, wobei eine Temperaturabhängigkeit des Widerstands des Kabels und des Kompensationskabels im Wesentlichen identisch ist.

Gemäß dem oben dargestellten Stand der Technik wird als Messstrecke ein Shunt verwendet, dessen Widerstand weitgehend temperaturunabhängig ist. Aufgrund der Erfindung kann auf diesen Shunt verzichtet werden, so dass entsprechend Kosten und Fertigungsaufwand eingespart werden können.

Das Kabel kann beispielsweise ein Massekabel sein, das einen Minuspol der Batterie mit einem elektrischen Leiter verbindet, an den Verbraucher mit ihrem Massepunkt angeschlossen sind. Beim elektrischen Leiter kann es sich insbesondere um eine Karosserie des Fahrzeugs handeln. Die Messstrecke muss nicht auf der Seite des Minuspols der Batterie angeordnet sein. In einer alternativen Ausführungsform befindet sich die Messstrecke am Pluspol der Batterie. Das Kabel kann somit auch ein Verbindungskabel sein, das einen Pluspol der Batterie mit z.B. einem Sicherungskasten verbindet. Wesentlich ist dabei, dass der gesamte Batteriestrom während der Messung über den Teil des Kabels fließt, der als Messstrecke dient.

Durch die Verwendung zumindest eines Teils des Massekabels bzw. des am Pluspol der Batterie angeordneten Verbindungskabels als Messstrecke kann auf den im Stand der Technik verwendeten Shunt verzichtet werden, wodurch erheblich Kosten sowie unter Umständen aufwendige Tätigkeiten im Fertigungsprozess vermieden werden können.

Das Multiplexen entlang der Messstrecke kann beispielsweise bedeuten, dass der vorherbestimmte Messstrom über die Messstrecke verläuft, aber vom Batteriestrom unterscheidbar ist. Genauso gut kann parallel zum Kabel ein weiteres Kabel verlaufen, so dass ein Raummultiplexverfahren zum Einsatz kommt.

Der Zweck der Widerstandskompensationseinrichtung hängt mit der Temperaturabhängigkeit des Widerstands des Kabels zusammen. Die Temperatur des Kabels muss über dessen Länge nicht notwendigerweise konstant sein. Um den Temperatureinfluss bei der Ermittlung des Batteriestroms herausrechnen zu können, kann ein bekannter Messstrom über eine zur Messstrecke äquivalente Strecke gesendet werden, deren Widerstand bei einer Referenztemperatur bekannt ist. Nach dem ohmschen Gesetz ergibt sich bei einem bekannten Strom und einem bekannten Widerstand zwangsläufig ein Spannungsabfall, der über diesen Widerstand abfällt. Wenn der gemessene Spannungsabfall vom erwarteten Spannungsabfall abweicht, kann diese Abweichung der Temperatur zugeschrieben werden. Unter der Annahme, dass die Messstrecke derselben Temperatur ausgesetzt ist, kann mithilfe dieser Abweichung der Temperatureinfluss auf den Widerstand der Messstrecke kompensiert werden.

Erfindungsgemäß kann das Multiplexen des vorherbestimmten Messstroms entlang der Messstrecke mittels verschiedener Verfahren bewerkstelligt werden, die entweder isoliert oder auch in Kombination verwendet werden können. Sämtliche Verfahren, die es erlauben, den vorherbestimmten Messstrom vom Batteriestrom zu unterscheiden, können verwendet werden. Bekannte Verfahren sind insbesondere das Raummultiplex-, Frequenzmultiplex-, Codemultiplex- und Zeitmultiplexverfahren.

Die im Wesentlichen identische Temperaturabhängigkeit des Kabels und des Kompensationskabels kann beispielsweise dadurch erreicht werden, dass das Kabel und das Kompensationskabel aus demselben Material bestehen.

Das Kompensationskabel kann bei einer Referenztemperatur einen bekannten Widerstand haben. Da es thermisch mit dem Kabel gekoppelt ist, kann davon ausgegangen werden, dass das Kabel und das Kompensationskabel denselben Temperatureinflüssen ausgesetzt sind. Für die räumliche Anordnung des Kabels und des Kompensationskabels bestehen unterschiedliche Möglichkeiten. Beispielsweise kann das Kabel als eine koaxiale Ummantelung des Kompensationskabels ausgestaltet sein. Alternativ ist es auch denkbar, dass das Kompensationskabel als eine koaxiale Ummantelung des Kabels ausgestaltet ist.

Durch eine vorteilhafte Anordnung des Kompensationskabels im Hinblick auf das Kabel kann beispielsweise eine Abschirmung gegen elektromagnetische Strahlung erreicht werden.

In einer Ausführungsform umfasst die erfindungsgemäße Vorrichtung einen Multiplexer zum Multiplexen des vorherbestimmten Messstroms über die Messstrecke und einen Demultiplexer zum Trennen des Messstroms vom Batteriestrom. Auf diese Weise kann der vorherbestimmte Messstrom über die Messstrecke gesendet werden und am Ende wieder vom Batteriestrom getrennt werden.

Der Demultiplexer kann beispielsweise als Filter oder Lock-In-Verstärker ausgestaltet sein. Darüber hinaus kann ein Frequenzgenerator zur Erzeugung eines vorherbestimmten Messstroms in Form eines Wechselstroms und/oder ein Codegenerator zur Erzeugung eines vorherbestimmten Messstroms mit einem aufmodulierten Code vorgesehen sein. Dabei ermöglichen der Frequenzgenerator ein Frequenzmultiplexverfahren und der Codegenerator ein Codemultiplexverfahren.

In einer Ausführungsform wird ein Zeitmultiplexverfahren verwendet. Die Vorrichtung umfasst dabei einen Schalter, der bewirken soll, dass in einer ersten Phase der Batteriestrom und in einer zweiten Phase der vorherbestimmte Messstrom über die Messstrecke fließt. Auf diese Weise ist der Batteriestrom vom vorherbestimmten Messstrom trennbar.

Die Messeinrichtung kann durch ein Messkabel und eine weitere elektrische Verbindung mit dem Kabel verbunden sein. Dabei kann zum Beispiel das Messkabel spiralförmig um das Kabel herumgewunden sein, um die Auswirkungen externen elektromagnetischer Felder zu vermindern.

Darüber hinaus kann das Kabel als eine koaxiale Ummantelung des Messkabels und/oder der weiteren elektrischen Verbindung ausgestaltet sein. Genauso ist es denkbar, dass das Messkabel und/oder die weitere elektrische Verbindung als eine koaxiale Ummantelung des Kabels dienen. Durch eine geschickte geometrische Anordnung der stromführenden Elemente können die Auswirkungen externen elektromagnetischer Felder, die möglicherweise störende Ströme induzieren, reduziert werden.

Darüber hinaus umfasst die Erfindung ein Fahrzeug mit einer Batterie und einer erfindungsgemäßen Vorrichtung zur Messung eines Batteriestroms einer Batterie.

Weitere Details der vorliegenden Erfindung werden im Folgenden mit Bezug auf die Figuren erläutert.

Dabei zeigen
- Figur 1: einen Stromkreis eines Fahrzeugs mit einer Batterie und einer Vorrichtung zur Messung eines Batteriestroms nach dem Stand der Technik;
- Figur 2: eine schematische Darstellung einer ersten Ausführungsform einer erfindungsgemäßen Vorrichtung;
- Figur 3: eine schematische Darstellung einer zweiten Ausführungsform einer erfindungsgemäßen Vorrichtung und
- Figur 4: eine schematische Darstellung einer dritten Ausführungsform einer erfindungsgemäßen Vorrichtung.

In der nachfolgenden Beschreibung sind gleiche und gleichwirkende Elemente, sofern nichts anderes angegeben ist, mit denselben Bezugszeichen benannt.

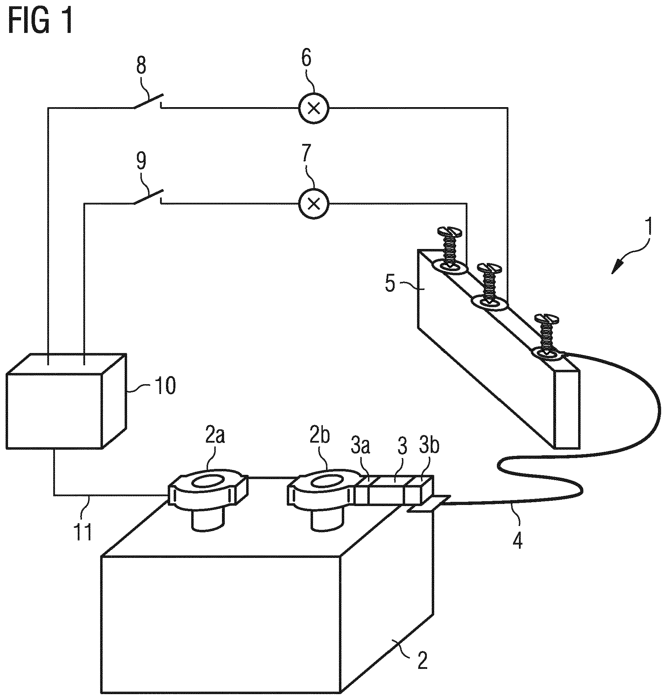

Figur 1 illustriert einen Stromkreis 1 eines Fahrzeugs mit einer Batterie 2 und eine Vorrichtung zur Messung eines Batteriestromes nach dem Stand der Technik. Die Batterie 2 weist einen Pluspol 2a und einen Minuspol 2b auf. Über einen ersten Anschlussbereich 3a ist ein Shunt 3 mit dem Minuspol 2b der Batterie 2 verbunden. Ein Massekabel 4 ist über einen zweiten Anschlussbereich 3b an den Shunt 3 angeschlossen.

Der Shunt 3 ist Teil eines nicht im Einzelnen dargestellten intelligenten Batteriesensors, der die Batterie 2 überwacht. Aus Messungen von Strom, Spannung und Temperatur wird mittels eines Prozessors und einer Software der Zustand und die Leistungsfähigkeit der Batterie 2 berechnet. Der fließende Batteriestrom wird dabei mit Hilfe der über den Shunt 3 abfallenden Spannung berechnet. Der Spannungsabfall wird über einen Verstärker und einen Analog-Digital-Wandler in ein digitales Signal gewandelt. Es können auch magnetische Methoden zum Einsatz kommen, die das vom Strom verursachte Magnetfeld erfassen. Dabei wird der sogenannte Hall-Effekt bzw. Magneto-resistive Effekt genutzt. Um exakte Ergebnisse bereit zu stellen, ist das Material des Shunts 3 dahingehend optimiert, dass die Temperatur des Shunts 3 einen nur geringen Einfluss auf dessen Widerstandswert besitzt.

Das am zweiten Anschlussbereich 3b des Shunts 3 angeschlossene Massekabel 4 ist an seinem gegenüberliegenden Ende mit der Karosserie 5 des Fahrzeugs verbunden. Vorzugsweise wird eine solche Verbindung mittels einer Schraube gesichert. Zwei beispielhaft als Lampe dargestellte Verbraucher 6 und 7 sind mit ihrem Massepunkt über entsprechende Verbindungen an der Karosserie angeschlossen. Über entsprechende Schalter 8 und 9 können die Stromkreise der Verbraucher 6 und 7 geschlossen werden, so dass die Lampen zu leuchten anfangen. Auf der Seite des Pluspols 2a der Batterie 2 sind die Stromkreise der Verbraucher 6 und 7 mittels Sicherungen gesichert, die sich in einem Sicherungskasten 10 befinden. Der Sicherungskasten 10 ist über ein Verbindungskabel 11 mit dem Pluspol 2a der Batterie 2 verbunden.

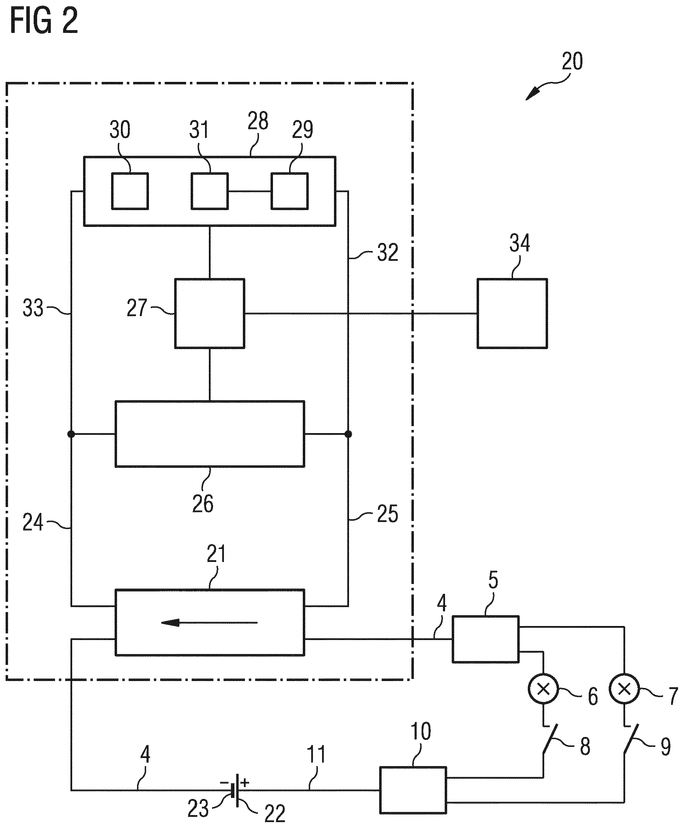

Figur 2 illustriert eine erste Ausführungsform einer erfindungsgemäßen Vorrichtung zur Messung eines Batteriestroms 20 anhand einer schematischen Darstellung. Die gezeigte Messstrecke 21 ist als ein Teil des Massekabels 4 ausgebildet. Das Massekabel ist an einer Seite wie bereits mit Bezug auf Figur 1 beschrieben wurde mit der Karosserie 5 verbunden. Die Massepunkte zweier Verbraucher 6 und 7 sind ebenfalls an der Karosserie 5 angeschlossen. Über zwei Schalter 8 und 9 sind die Verbraucher 6 und 7 mit dem Sicherungskasten 10 verbunden, der wiederum über ein Verbindungskabel 11 mit dem Pluspol 22 der

Batterie gekoppelt ist. Auf der anderen Seite ist das Massekabel 4 mit dem Minuspol 23 verbunden. Sobald einer der Schalter 8 oder 9 geschlossen ist, fließt der zu messende Batteriestrom über die Messstrecke 21. Über ein Messkabel 24 und eine weitere elektrische Verbindung 25 ist die Messstrecke 21 mit einer Messeinrichtung 26 verbunden, die einen Spanungsabfall über die Messstrecke 21 misst. Die Messeinrichtung 26 gibt den gemessenen Wert für den Spannungsabfall an eine Stromermittlungseinrichtung 27 weiter, die den Batteriestrom basierend auf dem gemessenen Spannungsabfall und dem Widerstand der Messstrecke 21 ermittelt. Der Widerstandswert der Messstrecke 21 hängt jedoch stark von dessen Temperatur ab. Erschwerend kommt hinzu, dass die Temperatur über die Länge der Messstrecke nicht notwendigerweise konstant sein muss.

Um den Einfluss der Temperatur auf den Widerstand der Messstrecke 21 heraus zu rechnen, umfasst die gezeigte Ausführungsform einer erfindungsgemäßen Vorrichtung 20 eine Widerstandskompensationseinrichtung 28. Diese weist einen Multiplexer 29, einen Demultiplexer 30 und einen Frequenzgenerator 31 auf. Vorzugsweise liegt die Frequenz des durch den Frequenzgenerator erzeugten Messstroms deutlich über den Frequenzen des Batteriestroms, damit der Demultiplexer 30 den Messstrom bequem vom Batteriestrom unterscheiden kann. Über die Leitungen 32 und 25 sendet der Multiplexer 29 den Messstrom über die Messstrecke 21. Über die Leitungen 24 und 33 wird der Stromkreis für den Messstrom geschlossen. Aufgrund des Spannungsabfalls, den der Messstrom auf der Messstrecke 21 verursacht, kann in Kombination mit dem bekannten Widerstand der Messstrecke 21 bei einer Referenztemperatur und dem bekannten Messstrom, der über die Messstrecke 21 fließt, die von der Temperatur verursachte Widerstandsänderung bestimmt werden. Die Widerstandsänderung wird anschließend von der Widerstandskompensationseinrichtung 28 zur Kompensation der Widerstandsänderung der Messstrecke 21 benutzt. Der nach der Kompensation resultierende Strom, der über die Messstrecke 21 fließt, wird zur weiteren Nutzung an eine Auswerteinheit 34 übergeben.

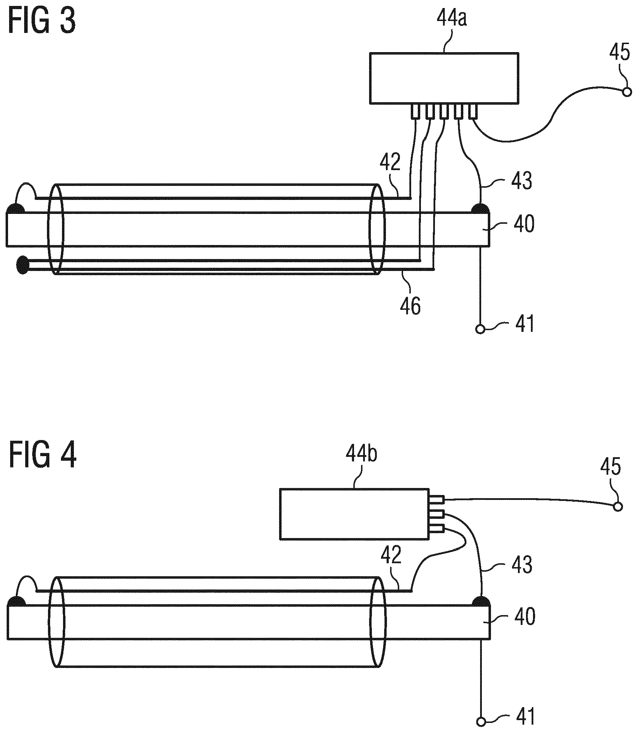

Figur 3 illustriert schematisch die wichtigsten Bestandteile einer zweiten Ausführungsform einer erfindungsgemäßen Vorrichtung, bei der ein Raummultiplexverfahren zum Einsatz kommt. Das Massekabel 40 ist Bestandteil eines in der Figur nicht gezeigten Stromkreises, der außerdem Verbindungen vom Pluspol der Batterie mit elektrischen Verbrauchern des Fahrzeugs und die Karosserie des Fahrzeugs enthält. Das als Messstrecke dienende Massekabel 40 ist an einem Ende mit einem Minuspol 41 einer Fahrzeugbatterie verbunden. Das andere Ende des Massekabels 40 ist mit der Karosserie des Fahrzeugs verbunden. Über ein Messkabel 42 und eine weitere elektrische Verbindung 43 wird ein über das Massekabel 40 auftretender Spannungsabfall gemessen. Hierfür verbinden das Messkabel 42 und die weitere elektrische Verbindung 43 eine Leiterplatte 44a mit dem Massekabel 40. Auf der Leiterplatte 44a befinden sich eine nicht gezeigte Messeinrichtung und eine Stromermittlungseinrichtung. Zum Zwecke der Stromversorgung der Leiterplatte 44a ist diese mit dem Pluspol 45 der Fahrzeugbatterie verbunden. Parallel zum Massekabel 40 verläuft ein mit dem Massekabel 40 thermisch gekoppeltes Kompensationskabel 46. Die Temperaturabhängigkeit des Widerstands des Massekabels 40 und des Kompensationskabels 46 sind im Wesentlichen identisch. Dies kann am einfachsten dadurch realisiert werden, dass das Material des Massekabels 40 und des Kompensationskabels 46 übereinstimmen. Dem Kompensationskabel 46 wird aus der Leiterplatte 44a heraus ein bekannter Messstrom aufgeprägt und der Spannungsabfall über das Kompensationskabel 46 mittels eines auf der Leiterplatte 44a angeordneten Analog-Digital-Wandlers ermittelt. In alternativen Ausführungsformen hätte zur Stromrückführung auch das Massekabel 40 oder das Messkabel 42 verwendet werden können.

Da das Material des Kompensationskabels 46 und dessen Temperatur identisch zum Material und der Temperatur des Massekabels 40 sind, ist auch das Verhältnis zwischen deren Widerstand bei einer Referenztemperatur und deren Widerstand bei der aktuellen Temperatur identisch. Daher ist der Widerstand des Massekabels 40 proportional zum Spannungsabfall am Kompensationskabel 46.

Auf diese Weise kann der Temperaturdrift des Widerstands des Massekabels 40 heraus gerechnet werden.

Besonders vorteilhaft ist in dem Ausführungsbeispiel in Figur 3, dass das Kompensationskabel 46 am gesamten Massekabel 40 entlang vor und zurück zur Leiterplatte 44a verläuft. So wird eine möglichst große Länge des Kompensationskabels 46 erreicht und damit ein möglichst großer, der Kabellänge proportionaler Widerstand. Damit werden die Anforderungen an die Präzision der Spannungsmessung, die zur Ermittlung der temperaturabhängigen Widerstandsänderung des Kompensationskabels 46 durchgeführt wird, verringert. Zugleich bildet das Kompensationskabel 46 einen geschlossenen Stromkreis außerhalb der Leiterplatte 44a ohne zusätzliche Verbindungselemente, die die Ermittlung der Widerstandsänderung des Kompensationskabels 46 beeinflussen könnten. Ein weiterer Vorteil dieser Ausführungsform ist, dass der dem Kompensationskabel 46 aufgeprägte bekannte Messstrom beispielsweise ein Gleichstrom sein kann, der mit besonders einfachen bzw. ohnehin auf der Leiterplatte 44a vorhandenen Mitteln zur Verfügung gestellt werden kann.

Die weitere elektrische Verbindung 43 kann beispielsweise als ein Kabel oder auch als eine elektrisch leitende Halterung für die Leiterplatte 44a an der Anschlussklemme des Kabels ausgestaltet sein. Das Messkabel 42 und die weitere elektrische Verbindung 43 können auch separat vom Massekabel 40 verlegt werden.

Generell können anstelle von Kabeln auch verschiedene andere Formen von elektrischen Leitern verwendet werden. Der Begriff eines Kabels ist gemäß der vorliegenden Patentanmeldung nicht auf einen runden Querschnitt beschränkt. Jede stromführende Form ist generell benutzbar. Beispielsweise können auch rechteckige Querschnitte zum Einsatz kommen. Darüber hinaus können das Massekabel 40, das Messkabel 42, die weitere elektrische Verbindung 43 und das Kompensationskabel 46 als einzelne Litzen eines Kabels ausgestaltet sein, wobei die Litzen elektrisch voneinander isoliert sind. Dennoch muss natürlich eine thermische Kopplung zwischen dem Massekabel 40 und dem Kompensationskabel 46 gewährleistet bleiben. Genauso können Koaxialkabel zum Einsatz kommen, bei denen ein oder mehrere der stromführenden Elemente 40, 42, 43 und 46 als koaxiale Ummantelung eines oder mehrerer stromführender Elemente 40, 42, 43, 46 dienen.

Typischerweise haben handelsübliche Massekabel eine Länge von etwa 50cm und einen Widerstand von etwa 100µOhm. Daher beträgt der Spannungsabfall am Massekabel bei Ruheströmen von etwa 20mA nur einige pV. Bei diesen Größenordnungen können Ströme, die durch ein externes elektromagnetisches Feld induziert werden, durchaus eine Rolle spielen. Daher kann es vorteilhaft sein, das Messkabel 42 spiralförmig um das Massekabel 40 herum zu winden.

Figur 4 zeigt eine schematische Darstellung einer dritten Ausführungsform einer erfindungsgemäßen Vorrichtung zur Messung eines Batteriestroms. Wiederum sind die Pole der Batterie mit den Bezugszeichen 41 und 45 versehen. Die Leiterplatte 44b umfasst unter anderem eine Messeinrichtung, eine Stromermittlungseinrichtung, einen Frequenzgenerator und einen Demultiplexer in Form eines Filters. Über das Messkabel 42 und die weitere elektrische Verbindung 43 wird der Spannungsabfall über das Massekabel 40 gemessen. Anders als bei der in Figur 3 gezeigten Ausführungsform kommt jedoch kein Kompensationskabel 46 zum Einsatz. Stattdessen liefert die Leiterplatte 44b mit Hilfe des Frequenzgenerators einen hochfrequenten Messstrom, der ebenfalls über das Massekabel 40 geleitet wird. Weil sich dessen Frequenz erheblich von den Frequenzen des Batteriestroms unterscheidet, kann der vom Messstrom verursachte Spannungsabfall mittels des Filters bestimmt werden. Auf der Basis des bekannten Messstroms kann der Widerstand des Massekabels 40 ermittelt und kompensiert werden.

Anstelle der Leiterplatten 44a, 44b kann auch ein Halbleiterchip, ein Dünnschichthybrid, ein Stanzgitter oder eine andere Art von elektrischem Schaltkreis verwendet werden.

Die mit Bezug auf die Figuren gemachten Erläuterungen sind rein illustrativ und nicht beschränkend zu verstehen. An den Ausführungsformen können erhebliche Änderungen vorgenommen werden, ohne den Schutzbereich, wie er in den beigefügten Ansprüchen festgelegt ist, zu verlassen. Darüber hinaus können die Merkmale der beschriebenen Ausführungsformen miteinander kombiniert werden, um für den jeweiligen Anwendungszweck optimierte weitere Ausführungsformen bereitzustellen.

### Bezugszeichenliste

- 1: Stromkreis eines Fahrzeugs
- 2: Batterie
- 2a: Pluspol
- 2b: Minuspol
- 3: Shunt
- 3a: erster Anschlussbereich des Shunts
- 3b: zweiter Anschlussbereich des Shunts
- 4: Massekabel
- 5: Karosserie
- 6,7: Verbraucher
- 8,9: Schalter
- 10: Sicherungskasten
- 11: Verbindungskabel
- 20: erste Ausführungsform einer erfindungsgemäßen Vorrichtung
- 21: Messstrecke
- 22: Pluspol der Batterie
- 23: Minuspol der Batterie
- 24: Messkabel
- 25: weitere elektrische Verbindung
- 26: Messeinrichtung
- 27: Stromermittlungseinrichtung
- 28: Widerstandskompensationseinrichtung
- 29: Multiplexer
- 30: Demultiplexer
- 31: Frequenzgenerator
- 32: Leitung
- 33: Leitung
- 40: Massekabel
- 41: Minuspol der Batterie
- 42: Messkabel
- 43: weitere elektrische Verbindung
- 44a: Leiterplatte
- 44b: Leiterplatte
- 45: Pluspol der Batterie
- 46: Kompensationskabel

## Patentansprüche

1. Vorrichtung zur Messung eines Batteriestroms einer Batterie eines Fahrzeugs, mit
- einer Messstrecke (21,40), über die der gesamte zu messende Batteriestrom während der Messung fließt,
- einer Messeinrichtung (26,44a,44b) zum Messen eines Spannungsabfalls über die Messstrecke (21,40) und
- einer Stromermittlungseinrichtung (27,44a,44b) zum Ermitteln des Batteriestroms basierend auf dem gemessenen Spannungsabfall und einem Widerstand der Messstrecke,
wobei die Messstrecke durch zumindest einen Teil eines Kabels mit einem temperaturabhängigen Widerstand (21,40) gebildet wird,
wobei die Vorrichtung dazu eingerichtet ist, einen vorherbestimmten Messstrom entlang der Messstrecke (21,40) zu multiplexen
und wobei
die Vorrichtung eine Widerstandskompensationseinrichtung aufweist (28,44a,44b), die dazu eingerichtet ist, einen Kompensationsspannungsabfall zu ermitteln, der aufgrund des vorherbestimmten Messstroms entlang der Messstrecke (21,40) abfällt, und den Widerstand der Messstrecke (21,40) mit Hilfe des Kompensationsspannungsabfalls und des vorherbestimmten Messstroms zu kompensieren,
**gekennzeichnet durch** ein parallel zum Kabel (40) verlaufendes mit dem Kabel thermisch gekoppeltes Kompensationskabel (46), wobei eine Temperaturabhängigkeit des Widerstands des Kabels und des Kompensationskabels im Wesentlichen identisch ist.

2. Vorrichtung nach Anspruch 1, **dadurch gekennzeichnet, dass** das Kabel ein Massekabel (21,40) ist, das einen Minuspol (23,41) der Batterie mit einem elektrischen Leiter, insbesondere einer Karosserie (5) des Fahrzeugs, verbindet, an den Verbraucher (6,7) mit ihrem Massepunkt angeschlossen sind, oder dass das Kabel ein Verbindungskabel (11) ist, das an einem Pluspol (22) der Batterie angeordnet ist.

3. Vorrichtung nach Anspruch 1 oder 2, **dadurch gekennzeichnet, dass** die Vorrichtung dazu eingerichtet ist, das Multiplexen mittels mindestens eines Verfahrens aus einer Gruppe von Raummultiplexverfahren, Frequenzmulitplexverfahren, Codemultiplexverfahren und Zeitmultiplexverfahren durchzuführen.

4. Vorrichtung nach einem der vorhergehenden Ansprüche, **gekennzeichnet durch** einen Multiplexer zum Multiplexen (29,44b) des vorherbestimmten Messstroms über die Messstrecke (21,40) und einen Demultiplexer (30,44b) zum Trennen des Messtroms vom Batteriestrom.

5. Vorrichtung nach Anspruch 4, **dadurch gekennzeichnet, dass** der Demultiplexer (30,44b) als Filter oder Lock-In-Verstärker ausgestaltet ist.

6. Vorrichtung nach Anspruch 4 oder 5, **gekennzeichnet durch** einen Frequenzgenerator (31,44b) zur Erzeugung eines vorherbestimmten Messstroms in Form eines Wechselstroms und/oder einen Codegenerator zur Erzeugung eines vorherbestimmten Messstroms mit einem aufmodulierten Code.

7. Vorrichtung nach einem der vorhergehenden Ansprüche, **gekennzeichnet durch** einen Schalter zum Bewirken, dass in einer ersten Phase nur der Batteriestrom und in einer zweiten Phase zusätzlich ein vorherbestimmter Messstrom über die Messstrecke fließt.

8. Vorrichtung nach einem der vorhergehenden Ansprüche, **dadurch gekennzeichnet, dass** die Messeinrichtung (26, 44a,44b) durch ein Messkabel (24,42) und eine weitere elektrische Verbindung (25,43) mit dem Kabel (21,40) verbunden ist.

9. Fahrzeug mit einer Batterie und einer Vorrichtung nach einem der vorhergehenden Ansprüche.

## Claims

1. Device for measuring a battery current of a battery of a vehicle, comprising
- a measurement path (21, 40), via which the total battery current to be measured flows during the measurement,
- a measuring apparatus (26, 44a, 44b) for measuring a voltage drop across the measurement path (21, 40), and
- a current determination apparatus (27, 44a, 44b) for determining the battery current on the basis of the measured voltage drop and a resistance of the measurement path,
wherein the measurement path is formed by at least part of a cable with a thermistor (21, 40), wherein the device is designed to multiplex a predetermined measurement current along the measurement path (21, 40)
and wherein
the device has a resistance compensation apparatus (28, 44a, 44b), which is designed to determine a compensation voltage drop which is present along the measurement path (21, 40) owing to the predetermined measurement current, and to compensate for the resistance of the measurement path (21, 40) with the aid of the compensation voltage drop and the predetermined measurement current,
**characterized by** a compensation cable (46), which runs parallel to the cable (40) and is thermally coupled to the cable, wherein a temperature dependence of the resistance of the cable and of the compensation cable is substantially identical.

2. Device according to Claim 1, **characterized in that** the cable is a grounding cable (21, 40), which connects a negative pole (23, 41) of the battery to an electrical conductor, in particular to a body (5) of the vehicle, to which conductor the grounding point of consumers (6, 7) are connected, or **in that** the cable is a connecting cable (11), which is arranged at a positive pole (22) of the battery.

3. Device according to Claim 1 or 2, **characterized in that** the device is designed to implement the multiplexing by means of at least one method from the group consisting of space-division multiplexing methods, frequency-division multiplexing methods, code-division multiplexing methods and time-division multiplexing methods.

4. Device according to one of the preceding claims, **characterized by** a multiplexer for multiplexing (29, 44b) the predetermined measurement current over the measurement path (21, 40) and a demultiplexer (30, 44b) for isolating the measurement current from the battery current.

5. Device according to Claim 4, **characterized in that** the demultiplexer (30, 44b) is configured as a filter or a lock-in amplifier.

6. Device according to Claim 4 or 5, **characterized by** a frequency generator (31, 44b) for generating a predetermined measurement current in the form of an alternating current and/or a code generator for generating a predetermined measurement current with a modulated code.

7. Device according to one of the preceding claims, **characterized by** a switch for ensuring that, in a first phase, only the battery current and, in a second phase, additionally a predetermined measurement current flows via the measurement path.

8. Device according to one of the preceding claims, **characterized in that** the measuring apparatus (26, 44a, 44b) is connected to the cable (21, 40) by a measurement cable (24, 42) and a further electrical connection (25, 43).

9. Vehicle comprising a battery and a device according to one of the preceding claims.

## Revendications

1. Dispositif de mesure du courant de batterie d'une batterie d'un véhicule, comportant
- un trajet de mesure (21, 40) par l'intermédiaire duquel le courant de batterie total à mesurer s'écoule pendant la mesure,
- un dispositif de mesure (26, 44a, 44b) destiné à mesurer une chute de tension sur le trajet de mesure (21, 40) et
- un dispositif de détection de courant (27, 44a, 44b) destiné à déterminer le courant de batterie sur la base de la chute de tension mesurée et d'une résistance du trajet de mesure,
dans lequel le trajet de mesure est formé par au moins une partie d'un câble ayant une résistance (21, 40) dépendant de la température,
dans lequel le dispositif est conçu pour multiplexer un courant de mesure prédéterminé le long du trajet de mesure (21, 40),
et dans lequel
le dispositif comporte un dispositif de compensation de résistance (28, 44a, 44b) qui est conçu pour déterminer une chute de la tension de compensation, qui s'abaisse en raison du courant de mesure prédéterminé le long du trajet de mesure (21, 40), et pour compenser la résistance du trajet de mesure (21, 40) au moyen de la chute de tension de compensation et du courant de mesure prédéterminé,
**caractérisé par** un câble de compensation (46) s'étendant parallèlement au câble (40) et couplé thermiquement au câble,
dans lequel les dépendances des résistances du câble et du câble de compensation vis-à-vis de la température sont sensiblement identiques.

2. Dispositif selon la revendication 1, **caractérisé en ce que** le câble est un câble de masse (21, 40) qui relie un pôle négatif (23, 41) de la batterie à un conducteur électrique, en particulier une carrosserie (5) du véhicule, auquel des charges (6, 7) sont connectées par leur point de masse, ou **en ce que** le câble est un câble de liaison (11) qui est disposé sur une borne positive (22) de la batterie.

3. Dispositif selon la revendication 1 ou 2, **caractérisé en ce que** le dispositif est conçu pour effectuer un multiplexage au moyen d'au moins un procédé choisi dans un groupe comprenant un procédé de multiplexage spatial, un procédé de multiplexage en fréquence, un procédé de multiplexage par code et un procédé de multiplexage par répartition dans le temps.

4. Dispositif selon l'une des revendications précédentes, **caractérisé par** un multiplexeur destiné à multiplexer (29, 44b) le courant de mesure prédéterminé sur le trajet de mesure (21, 40) et par un démultiplexeur (30, 44b) destiné à séparer le courant de mesure du courant de batterie.

5. Dispositif selon la revendication 4, **caractérisé en ce que** le démultiplexeur (30, 44b) est configuré sous la forme d'un filtre ou d'un amplificateur à verrouillage.

6. Dispositif selon la revendication 4 ou 5, **caractérisé par** un générateur de fréquence (31, 44b) destiné à générer un courant de mesure prédéterminé sous la forme d'un courant alternatif et/ou par un générateur de code destiné à générer un courant de mesure prédéterminé avec un code modulé.

7. Dispositif selon l'une des revendications précédentes, **caractérisé par** un commutateur destiné à faire en sorte que, lors d'une première phase, seul le courant de batterie s'écoule et que, lors d'une deuxième phase, un courant de mesure prédéterminé s'écoule en outre sur le trajet de mesure.

8. Dispositif selon l'une des revendications précédentes, **caractérisé en ce que** le dispositif de mesure (26, 35, 44a, 44b) est relié au câble (21, 40) par l'intermédiaire d'un câble de mesure (24, 42) et d'une autre liaison électrique (25, 43).

9. Véhicule comportant une batterie et un dispositif selon l'une des revendications précédentes.
